# EUROPEAN PATENT APPLICATION

(11) **EP 3 944 308 A1**
(43) Date of publication of application: **26.01.2022**
(21) Application number: 20186725.6
(22) Date of filing: 20.07.2020
(51) Int. Cl.: H01L 23/48, H01L 21/56, H01L 23/31, H05K 3/34, H05K 1/02

(54) **A SEMICONDUCTOR DEVICE AND A METHOD OF MANUFACTURE**

(71) Applicant: Nexperia B.V., 6534 AB Nijmegen (NL)
(72) Inventor: Bünning, Hartmut, 6534AB Nijmegen (NL); Funke, Hans-Juergen, 6534 AB Nijmegen (NL); Berglund, Stefan, 6534 AB Nijmegen (NL); Ramalingam, Vegneswary, 6534AB Nijmegen (NL); Tan, Justin YH, 6534AB Nijmegen (NL); Groenhuis, Roelf, 6534AB Nijmegen (NL); Stokkermans, Joep, 6534 AB Nijmegen (NL); Kniknie, Thijs, 6534AB Nijmegen (NL)
(74) Representative: Pjanovic, Ilija

(57) **Abstract**

A semiconductor device (200) comprising a frontside and a backside, four sidewalls, a first solder/glue connection (210) on the frontside and a second solder/glue connection (212) on the backside. The semiconductor device (200) connected as a chip scale package to a printed circuit board (202) so that the first solder/glue connection (210) and the second solder/glue connection (212) are visible for a visual solder/glue inspection.

## Description

### FIELD

The present invention relates to a semiconductor device. The invention also relates to a method of manufacturing a semiconductor device.

### BACKGROUND

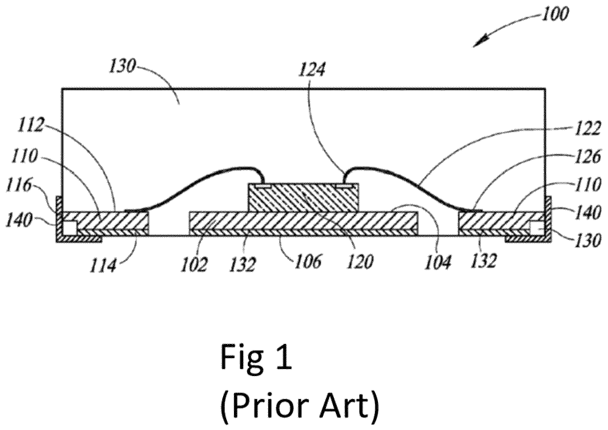

A known quad-flat no-leads (QFN) leadframe package is shown in Figure 1.

The package 100 includes a die pad 102 having inner and outer surfaces 104, 106. The package 100 further includes a plurality of leads 110, each having inner, bottom, and lateral surfaces 112, 114, 116. The die pad 102 and the leads 110 are formed from a leadframe, which is made of conductive material.

The leads 110 are located around the die pad 102 and form a recess at the corners of the package 100. The side surfaces of the package 100 meet with a bottom surface of the package 100. Due to the recess, first portions of the leads 110 proximate the lateral surface 116 of the leads 110 have first thicknesses. The second portions of the leads 110 proximate the bottom surface 114 of the leads 110 have second, different thicknesses. The first thicknesses of the first portions of the leads are less than the second thicknesses of the second portions of the leads, thereby forming the recesses. The bottom surfaces 114 of the leads 110 may be referred to as lands of the package and are configured to electrically couple the package 100 to another device or board, such as a printed circuit board (PCB).

The package 100 includes three leads 110 on each side of the package 100.

A semiconductor die 120 that includes one or more electrical components, such as integrated circuits, is bonded to the inner surface 104 of the die pad 102 by an adhesive material. The semiconductor die 120 is made from a semiconductor material and includes an active surface in which integrated circuits are formed. The integrated circuits may be analog or digital circuits.

Conductive wires 122 electrically couple the semiconductor die 120 to the leads 110. A first end 124 of the conductive wire 122 is coupled to a bond pad of the semiconductor die 120 and a second end 126 of the conductive wire 122 is coupled to the lead 110. The semiconductor die 120 may be flip chip coupled to the leads 110. In that regard, the semiconductor die 120 is mechanically supported by the leads 110 and electrically coupled directly to the leads 110 by solder balls.

Encapsulation material 130 is located over the die pad 102 and the leads 110 covering the semiconductor die 120 and the conductive wires 122 to form a package body. The encapsulation material 130 is also located between the leads 110 and the die pad 102 and forms a bottom surface of the package along with the outer surface 106 of the die pad 102 and the bottom surfaces 114 of the leads 110. The encapsulation material 130 fills the recesses of the leads 110 at the bottom edges of the package 100. The encapsulation material 130 is an insulative material that protects the electrical components and materials from damage, such as corrosion, physical damage, moisture damage, or other causes of damage to electrical devices and materials.

The bottom surfaces 114 of leads 110 and the outer surface 106 of die pad 102 may include plated conductive layers 132. The plated conductive layers 132 may be a nanolayer or a microlayer of one or more conductive materials. For instance, plated conductive layer is one or more metal materials. The plated conductive layers 132 are made from materials that prevent the leadframe from oxidizing. The inner surfaces 112 of the leads 110 and inner surface 104 of the die pad 102 may include plated conductive layers as well.

Wettable conductive layers 140 are located at the corners of the package 100 over the encapsulation material 130 and exposed surfaces of the leads 110, such as the bottom surfaces 114 and the lateral surfaces 116. Each of the wettable conductive layers 140 covers portions of the lateral and bottom surfaces 116, 114 of the leads 110 and the encapsulation material 130 therebetween. The wettable conductive layers 140 cover the entire lateral surfaces 116 and bottom surfaces 114 of the leads 110. The wettable conductive layers 140 extend beyond the lateral surfaces 116 of the leads 110 onto the encapsulation material 130 above the lead 110 to provide a larger surface area for joining material, such as solder.

The wettable conductive layers 140 may be a nanolayer or a microlayer of one or more conductive materials. The wettable conductive layers 140 can be made of any conductive material that provides a wettable surface for a joining material, such as solder, used during surface mounting of the package 100 to another device or board. The wettable conductive layers 140 enable solder to flow up the wettable conductive layers 140 on the side surface of package 100, thereby improving the solder joint between the package 100 and the board.

The disadvantage of the semiconductor devices as described above is that it is not possible to check the solder quality, since an automatic optical inspection is not possible, since the die pads are under the device.

Conventional inspection techniques utilise so-called Automated Optical Inspection (AOI) systems, whereby a camera scans the leadless packaged semiconductor devices mounted on the PCB for a variety of defects such as open circuit connections, short circuit connections, thinning of the solder connections and incorrectly placed devices. Due to the semiconductor device Input/Output (I/O) terminals being arranged on the bottom of the device, and therefore hidden from view when the device is mounted a PCB, it is not generally possible to use AOI systems with leadless semiconductor devices. Automatic XRay Inspection (AXI) systems may allow inspection of solder joints, however AXI systems are expensive.

### SUMMARY

Various example embodiments are directed to the disadvantage as described above and/or others which may become apparent from the following disclosure.

According to an embodiment of this invention a semiconductor device comprises a frontside and a backside, and four sidewalls. The semiconductor device further comprises a first solder/glue connection on the frontside and a second solder/glue connection on the backside. The semiconductor device is connected to a printed circuit board via one of the four sidewalls, so that the first solder/glue connection and the second solder/glue connection are visible for a visual solder/glue inspection.

According to an embodiment of this invention a semiconductor device comprises an isolating layer on four sidewalls.

The isolating layer can be a ceramic, parylene coating, mould, etc.

According to an embodiment of this invention an automotive part comprises a semiconductor device as specified above.

The invention also relates to a method of forming a semiconductor device as specified above.

In an embodiment of the invention the creation of the isolating layer on the four sidewalls comprises steps:
- singulate dies,
- coat the semiconductor device with ceramic, parylene, or other protection layer, and
- open contacts on the frontside and the backside using mechanical (e.g. bump planarization tool or grinder), chemical (e.g. plasma) or alternative ablation technology (e.g. laser).

In an embodiment of the invention the creation of the isolating layer on the four sidewalls comprises steps:
- singulate dies,
- overmold the semiconductor device,
- open contacts on the frontside and the backside by a grinding or an equivalent technology, e.g. plasma, laser etc., and
- singulate overmolded semiconductor devices.

The semiconductor device as described in the above embodiments allows an automatic optical inspection, since the semiconductor device is connected to a printed circuit board by one of the four sidewalls, so that the first solder connection and the second solder connection are clearly visible and therefore enabling the automatic visual inspection.

With this invention, the solder pad is moved to the sidewall of the semiconductor device, allowing automatic optical inspections.

For conventional DSN devices all terminals must be in one plane and which requires additional die area compared to a vertical device. This invention allows to stick to vertical current flow through a semiconductor chip.

A vertical DSN product, having solderable contacts on both sides of the device, while the non-contact areas are protected by an isolating layer will be mounted to the board on the sidewall. Die thickness defines the terminal pitch for diodes and for transistors the collector (drain) pitch to the other contacts.

This invention provides a solderable side wall contact on a chip scale package, which allows automatic optical inspection of the soldering contact, like it is required for automotive applications.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 shows a known QFN leadframe package;
Figure 2 illustrates a semiconductor device according to an embodiment of the invention;
Figure 3 illustrates method steps for manufacturing a semiconductor device according to an embodiment of the invention;
Figure 4 illustrates method steps for manufacturing a semiconductor device according to an embodiment of the invention.

### DETAILED DESCRIPTION

According to an embodiment of the invention a vertical designed device, e.g. a diode, a transistor, etc., comprises a solderable/glueable backside metallization and a solderable/glueable front side contact, e.g. a copper-tin (CuSn) bump, will be coated on side walls with a protection layer.

During coating, the devices will be mounted on a carrier, e.g. dicing foil, which prevents the backside from being covered.

The frontside contacts, if not protected during coating, needs to be re-opened after coating.

Bump planarization, grinding, polishing, etching or equivalent technology can be used for this purpose.

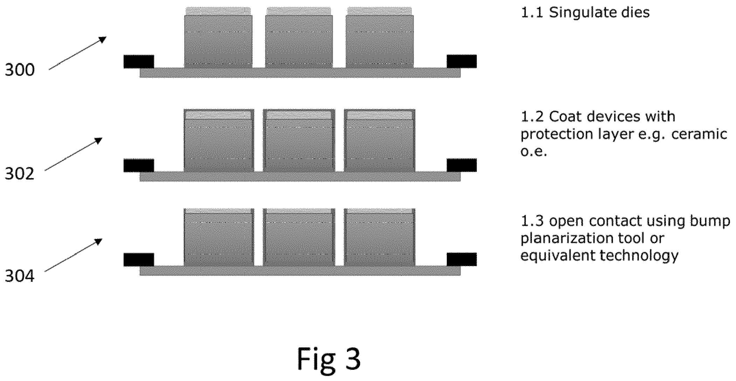

An embodiment of the invention is shown in Figure 3. In this case the device is coated by a ceramic or a parylene or a coating. The method comprises the steps:
- step 300: singulate dies
- step 302: coat devices with a protection layer, e.g. ceramic, parylene, etc.
- step 304: open contact using a bump planarization tool, grinder, or an equivalent technology

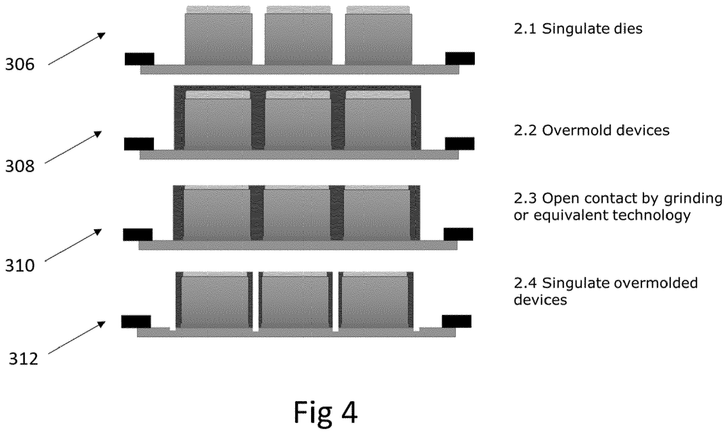

An embodiment of the invention is shown in Figure 4. In this case a mould type side wall protection is applied. The method comprises the steps:
- step 306: singulate dies
- step 308: overmold devices
- step 310: open contact by a grinding, etching, laser or an equivalent technology
- step 312: singulate overmolded devices

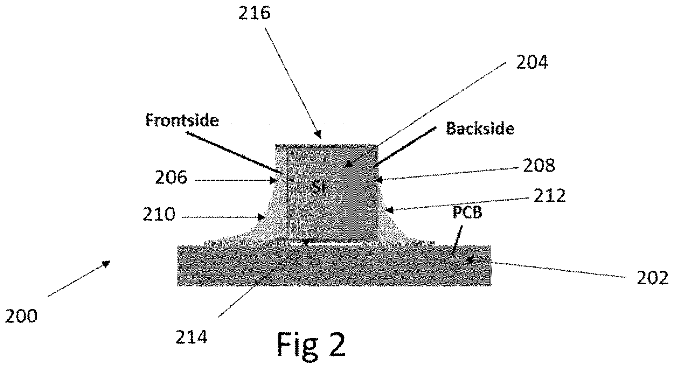

According to an embodiment of the invention shown in Figure 2, a semiconductor device 200 will be mounted with the sidewall to the PCB 202.

The semiconductor device 200 comprises a frontside 206, a backside 208 a first sidewall 214 and a second sidewall 216. The other two sidewalls are not visible in Figure 2. The semiconductor device further comprises a first solder connection 210 on the frontside 206 and a second solder connection 212 on the backside 208. The semiconductor device 200 is connected to printed circuit board 202 via the first sidewall 214 or via the second sidewall 216 or via other two sidewalls that are not visible in Figure 2. The first solder/glue connection 210 and the second solder/glue connection 212 are in this way visible, i.e. automatic optical inspection (AOI) of the solder/glue connection quality is enabled.

The semiconductor device with such a solderable/glueable side wall contact on a chip scale package allows automatic optical inspection of the solderable/glueable side wall contact. This is favourable in various applications, especially in automotive applications.

In other words, the semiconductor device is assembled on its original sidewall 214 or 216 or other two sidewalls and the frontside 206 and the backside 208 are used to place the solder/glue connections 210 and 212. The solder connections 210 and 212 are in such a semiconductor device representing side wettable flanks.

I.e. that means that the semiconductor device is mounted with the angle of 90°. Such mounting allows automatic optical inspection.

In this embodiment a die area is used for DSN devices by keeping vertical current flow through silicon. It is not required to bring all contacts of a device on one plane like it is done for a conventional DSN.

The wafer thickness, instead of the die area, is generating required distance, i.e. pitch, between the contacts.

Additionally, se secure that there are no shortcuts, a four-sided protection of the sidewalls using epoxy, ceramic, parylene, etc. can be used.

Thus, in such a vertical DSN semiconductor device, the solderable contacts are on the both sides of the DSN semiconductor device, while the non-contact areas are protected by an isolating layer, since it is mounted to the printed circuit board on the sidewall. Die thickness defines the terminal pitch for diodes and for transistors the collector or drain pitch to the other contacts.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A semiconductor device comprising:
- a frontside and a backside,
- four sidewalls,
- a first solder or glue connection on the frontside and a second solder or glue connection on the backside,
- wherein the semiconductor device is connected to a printed circuit board via one of the four sidewalls, so that the first solder or glue connection and the second solder or glue connection are visible for a visual solder or glue inspection.

2. A semiconductor device as claimed in claim 1, wherein the semiconductor device comprises an isolating layer on the four sidewalls.

3. A semiconductor device as claimed in claim 2, wherein the isolating layer is a ceramic, parylene or equivalent coating.

4. A semiconductor device as claimed in claim 2, wherein the isolating layer is a mould.

5. An automotive part comprising a semiconductor device as specified in any of the previous claims.

6. A method of forming a semiconductor device as specified in any of claims 1 to 4.

7. A method of forming a semiconductor device as claimed in claim 4, wherein the creation of the isolating layer on the four sidewalls comprises steps:
- singulate dies,
- coat the semiconductor device with ceramic, parylene, or other protection layer, and
- open contacts on the frontside and the backside using a bump planarization tool or grinding or etching, etc.

8. A method of forming a semiconductor device as claimed in claim 4, wherein the creation of the isolating layer on the four sidewalls comprises steps:
- singulate dies,
- overmold the semiconductor device,
- open contacts on the frontside and the backside by a grinding or an equivalent technology, and
- singulate overmolded semiconductor devices.
